# EUROPEAN PATENT APPLICATION

(11) **EP 4 525 313 A1**
(43) Date of publication of application: **19.03.2025**
(21) Application number: 23829505.9
(22) Date of filing: 16.03.2023
(51) Int. Cl.: H03M 13/11

(54) **DECODING PROCESSING METHOD AND APPARATUS, AND STORAGE MEDIUM AND ELECTRONIC APPARATUS**

(30) Priority: 27.06.2022 CN 202210738327
(71) Applicant: Sanechips Technology Co., Ltd., Shenzhen, Guangdong 518055 (CN)
(72) Inventor: ZHANG, Bingfeng, Shenzhen, Guangdong 518055 (CN); LONG, Zhijun, Shenzhen, Guangdong 518055 (CN)
(74) Representative: Savi, Massimiliano
(86) International application number: PCT/CN2023/082009
(87) International publication number: WO 2024/001313

(57) **Abstract**

Provided in the present application are a decoding processing method and apparatus, and a storage medium and an electronic apparatus. The method comprises: performing iterative decoding on input data by means of a plurality of decoders connected stage by stage, so as to obtain decoding results of the plurality of decoders; determining a target decoding result from among the decoding results of the plurality of decoders; and outputting the target decoding result.

## Description

### CROSS-REFERENCE TO RELATED APPLICATION

This application claims priority to Chinese Patent Application No. 202210738327.3 filed June 27, 2022, the entire contents of which is incorporated herein by reference.

### TECHNICAL FIELD

Embodiments of the present disclosure relate to the field of communication, and relate to a decoding processing method and device, a storage medium, and an electronic device.

### BACKGROUND

In recent years, the transmission rate of optical fiber communication has been growing at a high speed, but the increase in rate is accompanied by the emergence of constraints on the transmission distance. These physical constraints include chromatic dispersion, nonlinear effects, and polarization mode dispersion, among others. In order to reduce these adverse factors, a forward error correction technique (FEC) is proposed. FEC is a key technique for achieving long-distance high-speed optical fiber communication. It can improve the reliability of digital communication systems, and reduce the bit error rate to enhance the quality of communication in optical transmission systems. The low density parity check code (LDPC), which uses a soft decision decoding technique, is a highly promising error-correcting code. It is an FEC code capable of providing low redundancy overhead, strong error correction performance, and high encoding gain, which makes it the preferred encoding scheme for long-distance, relay-free high-speed transmission. However, the LDPC code requires a large number of decoding iterations and occupies considerable storage capacity, which makes the implementation of the entire system extremely complex.

For the problem in the related art that the LDPC code requires a large number of decoding iterations and occupies considerable storage capacity, which makes the implementation of the entire system extremely complex, no solution has been proposed.

### SUMMARY

Embodiments of the present disclosure provide a decoding processing method and device, a storage medium, and an electronic device, in order to address at least the problem in the related art that the LDPC code requires a large number of decoding iterations and occupies considerable storage capacity, which makes the implementation of the entire system extremely complex.

According to an embodiment of the present disclosure, a decoding processing method includes:
performing an iterative decoding on input data by a plurality of decoders connected in successive stages to obtain a plurality of decoding results of the plurality of decoders;
determining a target decoding result from the plurality of decoding results of the plurality of decoders; and
outputting the target decoding result.

According to another embodiment of the present disclosure, a decoding processing device includes:
an iterative decoding module configured to perform an iterative decoding on input data by a plurality of decoders connected in successive stages to obtain a plurality of decoding results of the plurality of decoders;
a first determination module configured to determine a target decoding result from the plurality of decoding results of the plurality of decoders; and
an output module for outputting the target decoding result.

According to yet another embodiment of the present disclosure, a computer-readable storage medium storing a computer program is disclosed. The computer program is configured to, when executed, cause the steps of any of the above method embodiments to be performed.

According to yet another embodiment of the present disclosure, an electronic device, including a memory and a processor, is disclosed. The memory stores a computer program, and the processor is configured to execute the computer program to implement the steps in any of the above method embodiments.

### BRIEF DESCRIPTION OF DRAWINGS

FIG. 1 is a block diagram of a hardware structure of a mobile terminal for a decoding processing method according to an embodiment of the present disclosure;
FIG. 2 is a flowchart of a decoding processing method according to an embodiment of the present disclosure;
FIG. 3 is a schematic diagram (I) of internal processing of an iterative decoder according to this embodiment;
FIG. 4 is a schematic diagram (II) of internal processing of the iterative decoder according to this embodiment;
FIG. 5 is a schematic diagram of an implementation of the decoder according to this embodiment;
FIG. 6 is a schematic diagram of a state machine corresponding to code block data input according to this embodiment;
FIG. 7 is a schematic diagram of timing of an iterative decoding of code block data inside each decoder according to this embodiment; and
FIG. 8 is a block diagram of a decoding processing device according to this embodiment.

### DETAILED DESCRIPTION

The embodiments of the present disclosure will be described in detail below with reference to the accompanying drawings in conjunction with embodiments.

It should be noted that the terms "first", "second", etc. in the description and the claims of the present disclosure and the above-mentioned drawings are intended to distinguish similar objects and are not necessarily to describe a specific order or sequence.

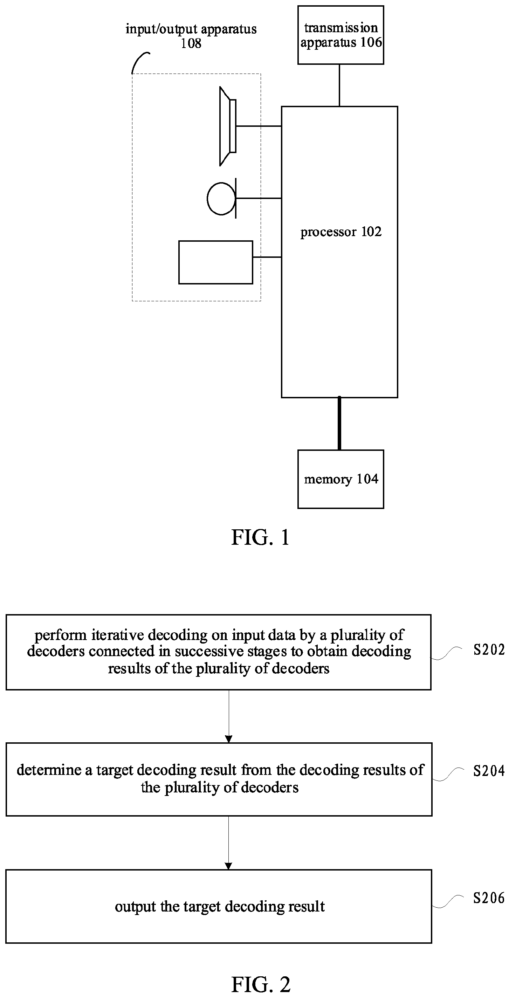

The method embodiment provided by the embodiments of the present disclosure can be executed in a mobile terminal, a computer terminal or a similar computing device. An example in which the method embodiment runs on a mobile terminal is provided. FIG. 1 is a block diagram of a hardware structure of a mobile terminal for a decoding processing method according to an embodiment of the present disclosure. As shown in FIG. 1, the mobile terminal may include one or more (only one is shown in FIG. 1) processors 102 which may include, but are not limited to, processing devices such as a microcontroller unit (MCU) or a field-programmable gate array (FPGA), and a memory 104 for storing data. The above mobile terminal may further include a transmission apparatus 106 for communication functions, and an input/output apparatus 108. Those having ordinary skill in the art can understand that the structure shown in FIG. 1 is only for illustrative purpose and does not impose a limitation on the structure of the mobile terminal. For example, the mobile terminal may alternatively include more or fewer components than the components shown in FIG. 1, or have a configuration different from that shown in FIG. 1.

The memory 104 may be used to store a computer program, for example, a software program and modules for application software, such as a computer program corresponding to the decoding processing method in embodiments of the present disclosure. The processor 102 executes various functional applications as well as transaction chain address pool slicing processing by running the computer program stored in the memory 104, thereby implementing the above method. The memory 104 may include a high-speed random access memory, and may also include a nonvolatile memory, such as one or more magnetic storage devices, a flash memory, or other nonvolatile solid-state memories. In some examples, the memory 104 may further include a memory remotely located with respect to the processor 102, and this remote memory may be connected to the mobile terminal via a network. Examples of the above-mentioned network include, but are not limited to, the Internet, an intranet, a local area network, a mobile communication network, and a combination thereof.

The transmission device 106 is configured to receive or send data via a network. Some examples of the network described above may include a wireless network provided by a communication provider of the mobile terminal. In an example, the transmission apparatus 106 includes a network interface controller (NIC), which can be connected to other network apparatuses through a base station to communicate with the Internet. In an example, the transmission device 106 may be a radio frequency (RF) module for wirelessly communicating with the Internet.

This embodiment provides a decoding processing method that runs on the mobile terminal or network architecture described above. FIG. 2 is a flowchart of a decoding processing method according to an embodiment of the present disclosure. As shown in FIG. 2, the process includes following steps.

At a step S202, an iterative decoding is performed on input data by a plurality of decoders connected in successive stages to obtain a plurality of decoding results of the plurality of decoders.

At a step S204, a target decoding result is determined from the plurality of decoding results of the plurality of decoders.

At a step S206, the target decoding result is output.

Through the above steps S202 to S206, the iterative decoding is performed on input data by a plurality of decoders connected in successive stages to obtain the plurality of decoding results of the plurality of decoders; a target decoding result is determined from the plurality of decoding results of the plurality of decoders; and the target decoding result is output. The problem in the related art that the LDPC code requires a large number of decoding iterations and occupies considerable storage capacity, which makes the implementation of the entire system extremely complex can be addressed by this scheme. The decoders are progressively activated as data is input, and a pipelined approach is used to achieve successive iteration and stage-by-stage decoding of the data. This reduces implementation complexity without requiring a large storage capacity.

This embodiment can be used in digital signal processing chips for optical coherent modulation and demodulation to support a 400G high-speed long-distance optical transmission system. It is used in optical transmission equipment, including backbone, metropolitan area, aggregation access, and data centers.

In an embodiment, the step S206 may further include the following steps for each of the plurality of decoders to iteratively decode the input data to obtain the plurality of decoding results of the plurality of decoders. The number of iterations i is greater than or equal to 1. Target data is picked from the input data and data decoded in the last iteration. In response to i being equal to 1, the target data is the input data. In response to i being greater than 1, the target data can be randomly selected or preferentially selected to be the data decoded in the last iteration. Decoding is performed on the target data to obtain decoded data. A hard decision is performed on the decoded data. In response to the hard decision being successful, the decoding is determined to be successful, and the decoded data is determined as the decoding result. Otherwise, in response to the hard decision failing, the decoded data is determined as data obtained after the current iterative decoding. i is updated to i+1 until i reaches a preset maximum number of iterations, and then the decoded data is determined as the decoding result.

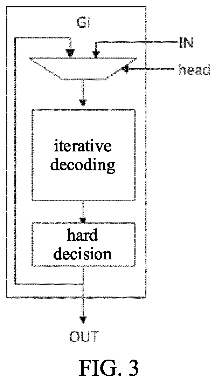

FIG. 3 is a schematic diagram (I) of internal processing of the iterative decoder according to this embodiment. As shown in FIG. 3, within the decoder, a two-to-one selection is made for the newly arrived input data, i.e., a selection between the new input data and the data decoded in the last iteration. The data decoded in the last iteration is preferentially selected, followed by the newly input data. The data selected through the two-to-one selection enters an iterative decoding which requires 6 clock cycles to complete the data decoding. After the iterative decoding, the data is output, thereby completing one decoding iteration process. The decoded data enters a hard decision. In response to the hard decision being successful, which means that there is no bit error, and this data block is successfully decoded, the data is directly output through the OUT port, and a decoding success flag signal is generated at the same time. In response to the result of the hard decision indicating a failure, the data of this data block is sent to a two-to-one MUX above the decoder for the next iterative decoding. In response to the number of iterations reaching the maximum number of iterations for LDPC decoding but the hard decision still failing, the code block data is output directly and a decoding failure flag signal is generated.

In an embodiment, performing a hard decision on the decoded data may further include a following step. It is determined whether there is a bit error in the decoded data. In response to a determination result indicating that there is a bit error, the hard decision fails; otherwise, in response to a determination result indicating that there is no bit error, the hard decision is successful.

In an embodiment, performing decoding on the target data to obtain decoded data may specifically include following steps. A cyclic shift processing is performed on the target data to obtain processed target data. A subtraction operation is performed between the processed target data and an input check matrix to obtain an operation result. The check matrix shares identical dimensions with the target data. For example, the target data and the parity check matrix are both 17*256 matrices. A minimum value and a second minimum value are picked from the operation result. For example, a minimum value and a second minimum value are picked from each column of values in the 17*256 matrix. The check matrix is updated according to the minimum value and the second minimum value to obtain an updated check matrix. For example, the minimum value in each row of data in the check matrix is updated to be the picked minimum value, and the other values is updated to be the picked second minimum value to obtain the updated check matrix. An addition operation is performed between the operation result and the updated check matrix, and then a cyclic reverse shift is performed to obtain the decoded data.

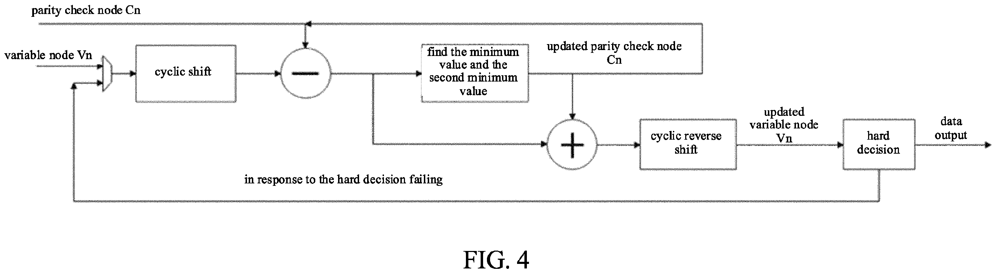

FIG. 4 is a schematic diagram (II) of internal processing of the iterative decoder according to this embodiment. As shown in FIG. 4, the externally input code block data corresponding to the input data is a variable node Vn in FIG. 4. After a cyclic shift, a subtraction operation is performed between the shifted data and the input check node Cn corresponding to the check matrix. Based on the result of the operation, the minimum value and the second minimum value in the matrix are found, and the minimum value and the second minimum value are used to update the verification node Cn for the current iterative calculation. Furthermore, an addition operation is performed between the result of the subtraction operation, namely, the operation result, and the updated check node Cn, namely, the updated parity check matrix, and then a cyclic reverse shift is performed, thereby completing one iterative operation and obtaining the updated variable node Vn, i.e., the decoded data. A hard decision is performed on the updated variable node Vn. In response to the hard decision being successful, which indicates that the current iterative decoding is successful, data is output. Otherwise, in response to the hard decision failing, which indicates that the current iterative decoding fails, and in response to the number of iterations having not been reached, the process continues to perform the next decoding iteration, with the data serving as the input data for the cyclic shift.

In an embodiment, before the above step S202, the method further includes a following step. A degree of parallelism of the input data and a delay requirement of received data are required to determine a number of decoders according to the degree of parallelism and the delay requirement. In general, the higher degree of parallelism and the shorter delay in the delay requirement are, the larger the number of decoders is; and the lower degree of parallelism and the longer delay in the delay requirement are, the smaller the number of decoders is.

In an embodiment, in a case where the input data is code block data, a number of code block data input to each decoder is determined according to a low density parity check code (LDPC) code block length. The number of code block data is a ratio of the LDPC code block length to the number of decoders.

In another embodiment, the step S206 may further include following steps. A first decoder is activated to cause the first decoder to enter a decoding state. When an m-th code block data is input, the iterative decoding is performed on the m-th code block data by the first decoder, and a state of the iterative decoding is recorded by head which is m-1, and tail which is 0. m is greater than or equal to 1, and less than or equal to a number x of code block data input to the decoder. head indicates a serial number of the input code block data, and tail indicates a number of rounds of decoding performed in parallel by the plurality of decoders. A j-th decoder is activated to cause the j-th decoder to enter the decoding state. When an m+(j-1)x-th code block data is input, the iterative decoding is performed on the m+(j-1)x-th code block data by the j-th decoder, and a state of the iterative decoding is recorded by head which is m+(j-1)x-1, and tail which is 0. j is greater than 1, and less than or equal to the number of decoders. After all of the plurality of decoders enter the decoding state, the iterative decoding is performed on the input code block data in parallel by the plurality of decoders.

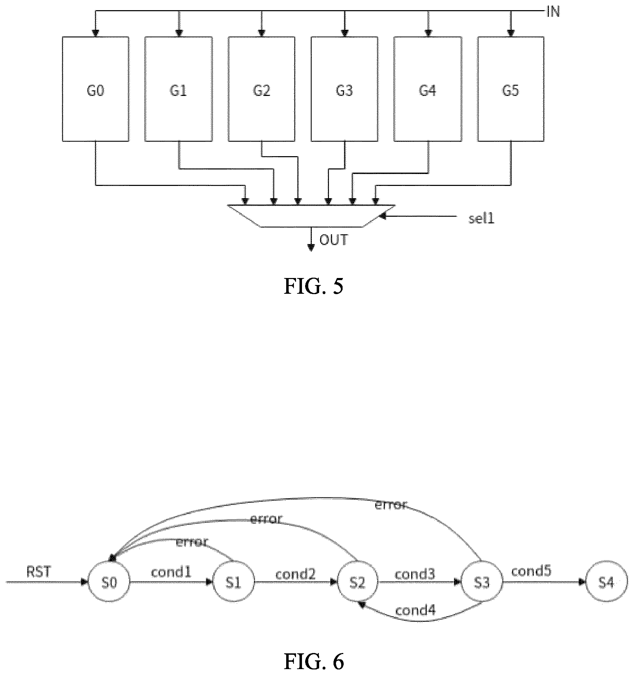

FIG. 5 is a schematic diagram of an implementation of the decoder according to this embodiment. As shown in FIG. 5, G0, G1, G2, G3, G4, and G5 share identical LDPC decoder structure. Each of the decoders receives the newly arrived data from the input terminal IN, and these data are output from below each decoder after undergoing a fixed number of iterations inside the decoder. Because all of the six decoders always have data output at different moments in time, a 6-to-1 MUX is added at the output terminal.

In this embodiment, the switches are progressively turned on and enabled as data is input, and a pipelined approach is used to achieve successive iteration and stage-by-stage decoding of data. This can effectively address the problem of system complexity due to a large number of iterations in LDPC decoding, without requiring a large storage capacity. It has been applied in 400G long-distance optical transmission projects, and can well meet the performance requirements of long-distance optical transmission.

The process of decoding is illustrated below using an example of an LDPC code block length of 36 and a maximum required number of decoding iterations of 12. The input 36 code blocks are stored in the above 6 decoders (G0-G5), respectively, with each decoder storing 6 code blocks. Every 3 code blocks of LDPC can be one completed one decoding, and 6 code blocks can be two completed decoding.

FIG. 6 is a schematic diagram of a state machine corresponding to code block data input according to this embodiment. As shown in FIG. 6, during initialization and reset, the state machine is in an S0 state. Upon input of the first clock cycle of the first code block data, the state machine transitions to an S1 state, and remains in this state when data of the second clock cycle and subsequent data are input.

When data of the 36 code blocks have been input, all the decoders enter an S2 state for decoding. After one iteration of decoding is completed, a hard decision is performed, that is, the state transitions to an S3 state. In response to a result indicating that the hard decision is successful in the S3 hard decision state, the data is directly output and the state transitions to an S4 state. Otherwise, the state returns to the S2 state for decoding. In response to the number of iterations of the code block having reached the maximum, but the output hard decision result still being failure, the state still transitions to the S4 state to directly output the data of the code block.

The following is a detailed explanation of the states:
- S0: the initial state;
- S1: the state in which 36 code blocks are input;
- S2: all 6 decoders are in the decoding state;
- S3: the decoded data enters a hard decision state;
- S4: the state in which the data is output after the hard decision is successful or the maximum number of iterations is reached;
- cond1: data of a first clock cycle of a first code block is input;
- cond2: data of all the 36 code blocks has arrived;
- cond3: one iteration is completed;
- cond4: the hard decision fails;
- cond5: the hard decision is successful or the maximum number of iterations is reached.

In the S0 initial state, two flag signals head and tail are set, and both flag signals are initialized to be 0. When the first data arrives and the state transitions to the S1 state, each time a complete code block is input, head is incremented by 1, and the tail value remains unchanged. A 6-bit switch En [5:0] is set inside each decoder, and the switches En inside the 6 decoders are all initialized to be 6'b000000 in the S0 state. For each decoder, each time a new code block enters, the corresponding En [i] is turned on, at which point the state transitions to the S1 state. For example, for the first decoder G0:
- when the first code block enters, En [0] is turned on, with head being 0 and tail being 0;
- when the second code block enters, En [1:0] is turned on, with head being 1 and tail being 0;
- when the third code block enters, En [2:0] is turned on, with head being 2 and tail being 0;
- when the fourth code block enters, En [3:0] is turned on, with head being 3 and tail being 0;
- when the fifth code block enters, En [4:0] is turned on, with head being 4 and tail being 0;
- when the sixth code block enters, En [5:0] is turned on, with head being 5 and tail being 0;
- next, when data of the seventh code block arrives, the switch En [1] of the second decoder G1 is turned on, with head being 6 and tail being 0;
- when data of the eighth code block arrives, the switch En [1:0] of the second decoder G1 is turned on, with head being 7 and tail being 0;
- when data of the 35th code block arrives, the switch En [4:0] of the sixth decoder G6 is turned on, with head being 34 and tail being 0; and
- when data of the 36th code block arrives, the switch En [5:0] of the sixth decoder G6 is turned on, with head being 35 and tail being 0.

At this point, the switches of all the decoders have been turned on. In response to a 37th code block and subsequent data arriving, the state transitions to the S2 state, with head being 0 and tail being 1. The switches previously turned on all remain on. This indicates that all the 6 decoders are in the decoding state and the pipeline is in a fully operational state.

Therefore, head indicates the serial number of the input code block data:
- when head = 0-5, the input code block enters the first decoder;
- when head = 6-11, the input code block enters the second decoder;
- when head = 12-17, the input code block enters the third decoder;
- when head = 18-23, the input code block enters the fourth decoder;
- when head = 24-29, the input code block enters the fifth decoder;
- when head = 30-35, the input code block enters the sixth decoder; and
- then, head starts counting from 0 again.

Tail can serve as a condition for state machine transition. After the first 36 code block data have been input, when there are new code blocks arriving, each time a new code block arrives, tail is incremented by 1. Therefore, when the value of tail is non-zero, the state machine in FIG. 3 transitions from the S1 state to the S2 state.

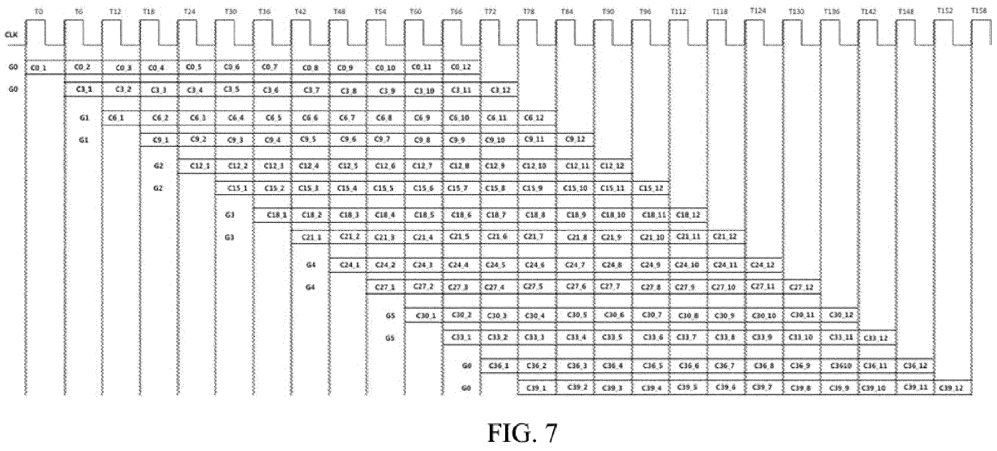

FIG. 7 is a schematic diagram of timing of the iterative decoding of code block data within each decoder according to this embodiment. The incoming code block data is sequentially numbered as C0, C1, C2, ..., and C35. As the code block data arrives, the timing of the iterative decoding of the code block data within each decoder is as shown in FIG. 7.

In FIG. 7, Ti represents the clock cycle which is accumulated in units of 6, indicating that the number of cycles of each iterative decoding is 6. Gi (i = 0-5) represents a certain decoder. Because there are 6 decoders in total, they are shown as G0, G1, G2, G3, G4, G5 in the figure. Ci_j denotes the decoding iteration number for a certain code block. Because each decoding needs to complete the collection of 3 code blocks of data before entering the decoding stage, here i denotes the serial number of the first code block among the 3 code blocks, and j denotes the decoding iteration number. For example, C0_1 within the T0-T6 period indicates that the first decoding iteration is performed on code blocks 0, 1, and 2; C3_1 within the T6-T12 period indicates that the first decoding iteration is performed on three code blocks numbered 3, 4, and 5; and C36_1 within the T72-T78 period indicates that the first decoding iteration is performed on three code blocks numbered 36, 37, and 38. Each iterative decoding requires 6 clock cycles to complete.

As can be seen from the timing diagram in FIG. 7, at the moment in time T72, the decoder G0 has just completed the iterative decoding of the code blocks 0, 1, and 2 for 12 times. At this point, three new code block data with code block serial numbers 36, 37, and 38 have been collected and enter the decoder G0 to start a new round of decoding iteration. At the moment in time T78, the decoder G0 has just completed the iterative decoding of the code blocks 3, 4, and 5 for 12 times. At this point, three new code block data with code block serial numbers 39, 40, and 41 have been collected and enter the decoder G0 to start a new round of decoding iteration. The other 5 decoders work in a similar manner. As can be seen, such pipelined decoders can efficiently complete the iterative decoding of multiple code blocks for multiple times without additional data storage units, thereby significantly reducing the resources and area of the decoder.

In the timing diagram of FIG. 7, the decoders are in the S1 state during the time T0-T66. From the moment in time T67, all the decoders enter the S2 decoding state. Each time the iterative decoding is completed for each code block data, it enters the S3 state, i.e., the hard decision state. Based on the result of the hard decision, it is determined whether the next decoding iteration is needed. In response to the hard decision being successful, it enters S4, i.e., data output state. At this point, all processes of decoding of this code block data are completed.

The number of decoders used in this embodiment can be adjusted according to the degree of parallelism of the input data and the delay of the received data. The higher degree of parallelism of the data and the smaller delay of the received data is, the larger number of decoders are required. The lower degree of parallelism of the data and the greater delay of the received data is, the smaller number of decoders are required.

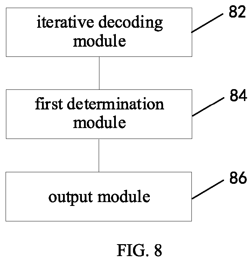

According to another embodiment of the present disclosure, a decoding processing device is provided. FIG. 8 is a block diagram of a decoding processing device according to this embodiment. As shown in FIG. 8, the device includes following modules.

An iterative decoding module 82 is configured to perform an iterative decoding on input data by a plurality of decoders connected in successive stages to obtain a plurality of decoding results of the plurality of decoders.

A first determination module 84 is configured to determine a target decoding result from the plurality of decoding results of the plurality of decoders.

An output module 86 is configured to output the target decoding result.

In an embodiment, the iterative decoding module 82 is further configured to perform the following steps for each of the plurality of decoders to iteratively decode the input data to obtain the plurality of decoding results of the plurality of decoders. The number of iterations i is greater than or equal to 1, target data is picked from the input data and data decoded in the last iteration. In response to i being equal to 1, the target data is the input data. The target data is decoded to obtain decoded data. A hard decision is performed on the decoded data. In response to the hard decision being successful, it is determined that the decoding is successful, and the decoded data is determined as the decoding result. Otherwise, in response to the hard decision failing, it is determined the decoded data as data decoded in the last iteration. i is updated to be i+1 until i reaches a preset maximum number of iterations, and then it is determined the decoded data as the decoding result.

In an embodiment, the iterative decoding module 82 is further configured to determine whether there is a bit error in the decoded data. In response to a determination result indicating that there is a bit error, the hard decision fails. Otherwise, in response to a determination result indicating that there is no bit error, the hard decision is successful.

In an embodiment, the device further includes following modules.

An acquisition module is configured to acquire a degree of parallelism of the input data and a delay requirement of received data.

A second determination module is configured to determine a number of decoders according to the degree of parallelism and the delay requirement.

In an embodiment, the device further includes a following modules.

A third determination module is configured to determine, in a case where the input data is code block data, a number of code block data input to each decoder according to a low density parity check code (LDPC) code block length. The number of code block data is a ratio of the LDPC code block length to the number of decoders.

In an embodiment, the iterative decoding module 82 is further configured to activate a first decoder to cause the first decoder to enter a decoding state. When an m-th code block data is input, the iterative decoding is performed on the m-th code block data by the first decoder, and a state of the iterative decoding is recorded by head which is m-1, and tail which is 0. m is greater than or equal to 1 and less than or equal to a number x of code block data input to the decoder. head indicates a serial number of the input code block data, and tail indicates a number of rounds of decoding performed in parallel by the plurality of decoders. A j-th decoder is activated to cause the j-th decoder to enter the decoding state. When an m+(j-1)x-th code block data is input, the iterative decoding is performed on the m+(j-1)x-th code block data by the j-th decoder, and a state of the iterative decoding is recorded by head which is m+(j-1)x-1, and tail which is 0. j is greater than 1 and less than or equal to the number of decoders. After all of the plurality of decoders enter the decoding state, the iterative decoding is performed on the input code block data in parallel by the plurality of decoders.

An embodiment of the present disclosure further provides a computer-readable storage medium storing a computer program. The computer program, when executed, causes the steps of any of the above method embodiments to be implemented.

In an example embodiment, the above-mentioned computer-readable storage medium may include, but is not limited to, various media that can store computer programs, such as USB flash drive, read-only memory (ROM), random access memory (RAM), mobile hard disk, magnetic disk or optical disk.

An embodiment of the present disclosure further provides an electronic device, including a memory and a processor. The memory stores a computer program, and the processor is configured to execute the computer program to implement the steps in any of the above method embodiments.

In an example embodiment, the electronic device above may further include a transmission apparatus and an input/output apparatus. The transmission apparatus is connected to the processor, and the input/output apparatus is connected to the processor.

Detailed examples of this embodiment may be referred to the examples described in the above embodiments and example implementations, so they will not be repeated here in this embodiment.

Obviously, those having ordinary skill in the art should understand that the above modules or steps of the present disclosure may be implemented by a general-purpose computing device and may be concentrated in one single computing device or distributed in a network composed of a plurality of computing devices, and may be implemented by program codes executable by a computing device, so that they can be stored in a storage device and executed by the computing device(s). Moreover, in some cases, the steps shown or described herein can be performed in a different order, or they can be made into individual integrated circuit modules, or a plurality of the modules or steps can be made into one single integrated circuit module. As such, the present disclosure is not limited to any specified combination of hardware and software.

The above is only the description of some preferable embodiments of the present disclosure, and is not intended to limit the present disclosure. It will be apparent to those having ordinary skill in the art that various modifications and variations can be made to the present disclosure. Any modifications, equivalent substitutions, improvements, etc. made within the principle of the present disclosure shall fall within the scope of protection of the present disclosure.

## Claims

1. A decoding processing method, comprising:
performing an iterative decoding on input data by a plurality of decoders connected in successive stages to obtain a plurality of decoding results of the plurality of decoders;
determining a target decoding result from the plurality of decoding results of the plurality of decoders; and
outputting the target decoding result.

2. The method of claim 1, wherein performing an iterative decoding on input data by a plurality of decoders connected in successive stages to obtain a plurality of decoding results of the plurality of decoders comprises:
performing the following steps for each of the plurality of decoders to iteratively decode the input data to obtain the plurality of decoding results of the plurality of decoders:
picking target data from the input data and data decoded in the last iteration, wherein the number of iterations i is greater than or equal to 1, and in response to i being equal to 1, the target data is the input data;
performing decoding on the target data to obtain decoded data;
performing a hard decision on the decoded data;
in response to the hard decision being successful, determining that the decoding is successful, and determining the decoded data as the decoding result;
in response to the hard decision failing, determining the decoded data as data obtained after the current iterative decoding; and
updating i to be i+1 until i reaches a preset maximum number of iterations, and then determining the decoded data as the decoding result.

3. The method of claim 2, wherein performing a hard decision on the decoded data comprises:
determining whether a bit error is in the decoded data;
in response to a determination result indicating a bit error, the hard decision fails; and
in response to a determination result indicating no bit error, the hard decision is successful.

4. The method of claim 2, wherein performing decoding on the target data to obtain decoded data comprises:
performing a cyclic shift processing on the target data to obtain processed target data;
performing a subtraction operation between the processed target data and an input check matrix to obtain an operation result, wherein the check matrix shares identical dimensions with the target data;
picking a minimum value and a second minimum value from the operation result;
updating the check matrix according to the minimum value and the second minimum value to obtain an updated check matrix; and
performing an addition operation between the operation result and the updated check matrix, and then performing a cyclic reverse shift to obtain the decoded data.

5. The method of any one of claims 1 to 4, wherein before performing an iterative decoding on input data by a plurality of decoders connected in successive stages to obtain decoding results of the plurality of decoders, the method further comprises:
acquiring a degree of parallelism of the input data and a delay requirement of received data; and
determining a number of decoders according to the degree of parallelism and the delay requirement.

6. The method of claim 1, further comprising:
in response to the input data being code block data, determining a number of code block data input to each decoder according to a low density parity check code (LDPC) code block length, wherein the number of code block data is a ratio of the LDPC code block length to the number of decoders.

7. The method of claim 6, wherein performing an iterative decoding on input data by a plurality of decoders connected in successive stages comprises:
activating a first decoder to cause the first decoder to enter a decoding state, and in response to an m-th code block data being input, performing the iterative decoding on the m-th code block data by the first decoder, and recording a state of the iterative decoding by head which is m-1, and tail which is 0, wherein m is greater than or equal to 1 and less than or equal to a number x of code block data input to the decoder, head indicates a serial number of the input code block data, and tail indicates a number of rounds of decoding performed in parallel by the plurality of decoders;
activating a j-th decoder to cause the j-th decoder to enter the decoding state, and in response to an m+(j-1)x-th code block data being input, performing the iterative decoding on the m+(j-1)x-th code block data by the j-th decoder, and recording a state of the iterative decoding by head and tail, wherein head is m+(j-1)x-1, tail is 0, and j is greater than 1 and less than or equal to the number of decoders; and
after all of the plurality of decoders enter the decoding state, performing the iterative decoding on the input code block data in parallel by the plurality of decoders.

8. A decoding processing device, comprising:
an iterative decoding module configured to perform an iterative decoding on input data by a plurality of decoders connected in successive stages to obtain a plurality of decoding results of the plurality of decoders;
a first determination module configured to determine a target decoding result from the plurality of decoding results of the plurality of decoders; and
an output module configured to output the target decoding result.

9. A computer-readable storage medium storing a computer program, which, when executed, causes the method of any one of claims 1 to 7 to be performed.

10. An electronic device, comprising a memory, a processor, and a computer program stored in the memory, wherein the computer program, when executed by the processor, performs the method of any one of claims 1 to 7.
